# EUROPEAN PATENT SPECIFICATION

(11) **EP 4 470 038 B1**
(45) Date of publication and mention of the grant of the patent: **01.07.2026**
(21) Application number: 22922730.1
(22) Date of filing: 27.01.2022
(51) Int. Cl.: H10F 19/31, H10F 77/20

(54) **INKJET PRINTER FOR FORMING CRISSCROSSED CONDUCTIVE LINES OF THIN-FILM SOLAR MODULE AND AUTOMATED METALLIZATION SYSTEM**
TINTENSTRAHLDRUCKER ZUR HERSTELLUNG VON ÜBERKREUZTEN LEITERBAHNEN EINES DÜNNSCHICHTSOLARMODULS UND AUTOMATISIERTES METALLISIERUNGSSYSTEM
IMPRIMANTE À JET D'ENCRE POUR FORMER DES LIGNES CONDUCTRICES ENTRECROISÉES DE MODULE SOLAIRE À FILM MINCE ET SYSTÈME DE MÉTALLISATION AUTOMATISÉ

(43) Date of publication of application: 04.12.2024
(73) Proprietor: Triumph Science & Technology Group Co., Ltd., Beijing 100036 (CN); CNBM RESEARCH INSTITUTE FOR ADVANCED GLASS MATERIALS GROUP CO., LTD, Bengbu, Anhui 233010 (CN)
(72) Inventor: SHEN, Yilei, 81739 Munich (DE); GADDIGOPULA, Bala-Krishna, 81739 Munich (DE); LEI, Xiaojun, 81739 Munich (DE); XIE, Chenbo, 81739 Munich (DE)
(74) Representative: INNOV-GROUP
(86) International application number: PCT/CN2022/074345
(87) International publication number: WO 2023/141884

(56) References cited:
- WO-A1-2014/081051
- CN-A- 105 489 666
- CN-A- 105 489 666
- CN-A- 111 247 643
- CN-A- 113 306 320
- JP-A- 2013 201 217
- US-A1- 2010 139 756

## Description

### Technical Field

This disclosure relates to a technical field of solar energy, and in particular to an inkjet printer for forming crisscrossed conductive lines of a thin-film solar module and an automated metallization system having the same.

### Background

In general, a thin-film solar cell consists of a back electrode layer, an absorber layer, a buffer layer/i-layer, and a front electrode layer in sequence. Due to low voltage and large area of the cell, most thin-film solar modules are designed to inter-connect their individual solar cells in monolithic series, in order to avoid high current losses. However, it will increase the total operation voltage in the solar modules.

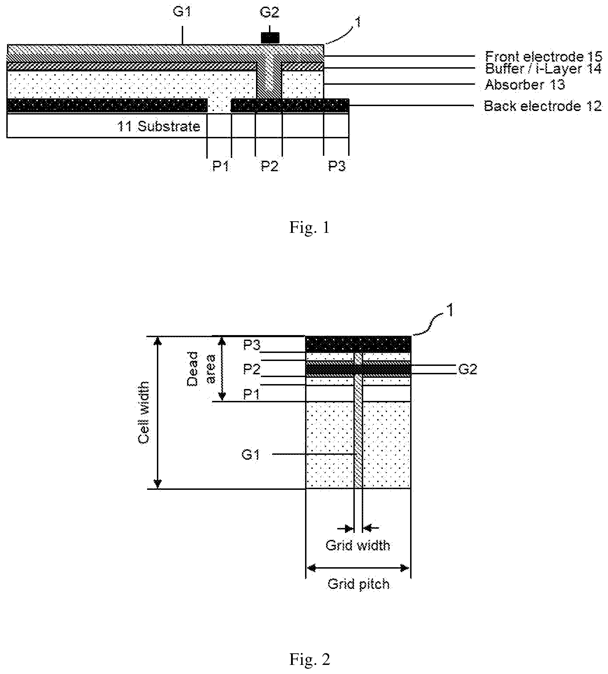

The individual layers in the cell are interconnected, as shown in Fig.1. These layers are separated by P1, P2 and P3 structuring lines, respectively. The P1 structuring line and P3 structuring line insulate the back electrode layer and the front electrode layer, and the P2 structuring line serves as an electrical contact between the back electrode layer and the front electrode layer for serial connection of two neighboring cells. Since the structuring area of the P1, P2 and P3 structuring lines does not generate electricity, it usually refers to as the "dead area", see Fig. 2.

To optimize the power conversion efficiency of the solar cell, one approach is often considered, e.g. increasing the transmission of the front electrode layer of the solar cell by reducing the thickness of the front electrode layer and further the photo current generated. However, it will lead to an increase in the sheet resistance of the front electrode layer, causing ensuing conduction losses. To reduce such conduction losses in the front electrode layer, highly conductive narrow metal grid lines (which are referred to as the first type of grid lines) can be applied on the front electrode layer to improve related electrical conductivity, which refers to as a metallization process in the solar module production. In the metallization process, the first type of grid lines are deposited transversely on the top of the front electrode layers of the solar cells or perpendicular to the P1/ P2/P3 structuring lines at periodic intervals. Further, the first type of grid lines are deposited continuously over the front electrode layers of the solar cells. The P3 structuring line interrupts the first type of grid lines to prevent a short circuit between the front electrodes of one cell and its neighboring cell.

The first type of grid lines can reduce the conduction losses of the front electrode layer. However, the grid lines also lead to an increase in the dead area due to the shading of the grid lines, and further cause additional optical losses. Besides, the application of the first type of grid lines also can lead to a concentrated current at an end of a cell. In the case of a monolithic interconnected cell, the current collected at the first type of grid lines flows to an end of the cell and needs to be evenly distributed at the beginning of the next cell. Otherwise, further conduction losses in the front and back electrode layers will arise.

Therefore, an additional grid line, which is referred to as the second type of grid line, is deposited within the dead area and perpendicular to the first type of grid lines. Here, the first type of grid line is denoted as G1, and is perpendicular to the P2 structuring line; the second type of grid line is denoted as G2, and is deposited exactly on the P2 structuring line or parallel to the P2 structuring line. The intention of depositing the G2 grid line is to evenly distribute the current and reduce electrical loss along P2 structuring line interconnect between two G1 grid lines, which is caused by current distribution from the G1 grid lines raised at the beginning of the next cell. Since the G2 gird line is placed in the dead area, it will not cause additional optical loss by shading. Besides, the G2 grid line can improve the generation of photo current, which is contributed to the light reflection at the G2 grid line onto the back of the over layer/front glass and further into the active cell area.

Therefore, the precise deposition of the G2 grid line is needed regarding the exact electrical and optical management in the dead area. In addition, when G2 crosses the P3 line edges, it might cause shunts, and when G2 crosses the below line edge of P1 (in the Fig.2), it will cause optical loss in the active area.

Concerning the mass production of thin-film solar modules using metal grid lines (G1 and G2 grid lines) for the enhancement of front contact, there is generally a need for a manufacture process of low CAPEX cost, short circle time and high production throughput. In addition, the metal grid lines (G1 and G2 grid lines) need to be deposited in two totally different directions of 0° and 90°. To realize it, additional accurate handling/alignment aggregates are required to change a printing/machine direction, or the double number of printing and conveyor units are required to complete the deposition of G1 and G2 grid lines. Thus, it will increase the CAPEX cost and production circle time. Additionally, possible misalignment during rotation/handling of the thin-film solar module will also lead to wrong positioning of the G2 grid line.

In the prior art, commercial thin-film/CIGS photovoltaic manufacturers (Solibro Hi-Tech GmbH / Beijing Apollo Ding Rong Solar Technology Co., Ltd) or (NICE Solar Energy GmbH) and its related research institutions (National Institute of Clean-and-Low-Carbon Energy, Department of Mechanical Engineering of Tsinghua University Beijing) presented their methods to deposit metal grid lines on the front electrode layers of CIGS modules.

Solibro Hi-Tech GmbH provides a method referred to as ALD (Aluminum Line Deposition) method, which is to deposit an aluminum conductive line structure through a mask via a thermal evaporation method. Various drawbacks in this method are 1) low production throughput and yield by using mask, 2) high cost of such special mask for the production of large area module, 3) high material waste due to evaporation, 4) high maintenance efforts for masks, 5) limitation in the widths of metal grid lines (too narrow mask opening, less than several hundred micrometers, will be easily clogged during/after usage). All these drawbacks mentioned above are relevant for deposition of general metal grid lines, mostly G1 grid lines. If the thermal evaporation method is used for the deposition of the G2 grid lines, it could be expected that the G1 and G2 grid lines will be very difficult to be deposited simultaneously due to shadowing effect.

Nice Solar Energy GmbH uses a screen printing method to deposit the G1 grid lines, and uses an e-beam evaporation method to deposit the G2 grid lines. The screen printing method is not suitable to be used to print the G1 grid lines on large area solar module, since it has the following critical technical limitation. The larger the printing pattern is, the less deposition accuracy and line shape of the G1 grid lines will be kept in the middle region of the large printing area (e.g. >1m²) due to less stiffness of the large screen mesh in the center. Also, the printing of narrow gird lines by the screen printing method will require a high quality screen mesh, e.g. hardened stainless steel mesh calendered, or knotless screen mesh. For the full size thin-film solar module (e.g. >1m²), those high quality screen meshes of large size are very difficult to be manufactured and extremely expensive. And, a screen mesh for printing the grid lines is prone to be clogged and difficult to be cleaned. Usually, a Si-PV (6"×6") screen mesh will be scrapped after certain printing processes without cleaning. In addition to high cost of using screen printing method for large thin-film modules, it is also quite inflexible to change the printing pattern of grid lines, in case that the line pitch of the grid line need be adjusted for production samples.

Furthermore, there is the following drawback in deposition of G2 grid lines by the screen printing method. In the case of printing G1 grind lines and G2 grid lines simultaneously, the deposition accuracy and line widths of the G2 grid lines are very limited, since the stiffness of screen mesh is difficult to be kept in both direction (0° and 90°) due to opening. Loss in the stiffness of screen mesh causes the decrease in the deposition accuracy of the G2 grid lines and the broadening in the widths of the G2 gird lines. Accordingly, printed grid lines may be S-shaped. As mentioned before, the optimal deposition of G2 grid lines means that the G2 grid lines is placed very precisely in the dead area close to the P2 structuring lines and is not be placed across the edges of the P1 and P3 structuring lines. Otherwise, the G2 grid lines will create additional optic losses in the active cell area or shunts. Since the thin-film solar modules in production have a very process window for P2 structuring lines, there is large variation in the line pitch and shape of the P2 structuring line. Due to inherent inflexible printing strategy of the screen printing method, it is almost impossible to do quick adjustment in the production. In another case of two-step printing of G1 and G2 grid lines, in which the G2 grid line are printed after the G1 grid lines are printed, other issues are encountered. Unlike double-printing (used in Si-PV to deposit 2-layer prints to increase the heights of G1 grid lines), not-cured and soft G1 grid lines will be easily ruined by the squeegee during printing G2 grid lines in the direction of 90°. In the case that the G1 grid lines are first printed and cured, and then the G2 gird lines are printed and cured, there are two curing processes for the G1 and G2 grid lines. Thus, the thin-film solar module might be damaged due to overshoots of thermal energy. And, two printing and curing processes will also increase the CAPEX and OPEX cost.

In addition to the conventional screen printing method, there is also an alternative rotary screen printing method for the deposition of the conductive grid lines, which is only suitable for Si-PV (6"×6" wafers). For the large-area thin-film solar module, the rotary screen printing method has the drawbacks similar to the conventional screen printing method. For large printing width (600~1300mm), the selected rotary tube material is difficult to keep the sufficient stiffness so that the deposition accuracy and width of the grid lines will be strongly affected. In the worst case, the grid lines in the middle region of the entire solar module will be S-shaped.

Furthermore, the e-Beam evaporation process for printing the G2 gird lines, as reported by Nice Solar Energy GmbH, is only suitable for the lab-scale, but not for mass production, since it is a full-area coating process. Such a method will possess the drawbacks and limitations similar to the thermal evaporation method, e.g., mainly low production throughput and high cost.

In the prior art, there are other process methods, such as an aerosol jet printing method, a dispensing method, which are quite new technologies for the metallization process, and still have strong process stability issues. The nozzles of aerosol jet and dispenser are prone to be clogged by metal particles during long-term printing, which leads to frequent process downtime. In addition, the upscale of these two methods is still in the early development. The maximum number of grid lines (G1) that can be printed simultaneously is 5~10. For the large-area thin-film solar module (which may have up to 1000 G1 grid lines and few hundred G2 grid lines), many printing passes are required, i.e. very low throughput is currently encountered for the aerosol jet printing method. Further increase in the number of nozzles for dispensing or aerosol jetting is not easy as the numbering-up route for inkjet printing, since the paste/aerosol distribution along the horizontal direction in the printing head is extremely challenging. At present, 10 nozzles are almost the bottle-neck for both technologies. Furthermore, it is only possible to deposit the G2 grid lines in the direction perpendicular to the G1 grid lines by changing the machine/printing direction for the dispensing and aerosol jetting methods.

Furthermore, there are some other metallization methods. In these methods, the conventional inkjet printing technology is used to apply metal grid lines on thin-film organic PV modules or Si-solar modules. In these metallization methods, inkjet printing was used to apply straight grid lines (that is, G1 grid lines). This kind of linear pattern formation is only realized by overlap of droplets jetted by the same nozzle in one printing direction. However, in the process of printing the G2 gird lines, it is necessary to rotate the solar module to print the G2 grid lines in the direction perpendicular to the direction of printing the G1 grid lines. Further, jetted droplets for G2 grid lines have a spacing of few hundred micrometers and thus cannot be connected in the direction perpendicular to the direction of printing the G1 grid lines. As conclusion, these conventional inkjet printing strategies cannot fulfill the mass production requirements of low circle time and high throughput without additional rotation/handling to print G1 and G2 grid lines.

Various inkjet metallization production tools have been presented in the prior art. However, they either focus on Si-PV (6"×6") wafer, or linear inline printing process integration for flexible thin-film devices. In these inkjet metallization production tools, inkjet printing of linear pattern for G1 grid lines is possible in the large-area thin-film solar module by numbering-up of print heads or multi-step printing. However, for G2 grid lines, these inkjet metallization production tools will change the printing/machine direction to print the G2 grid lines. Therefore, these inkjet metallization production tools cannot fulfill the mass production requirements of low circle time and high throughput without additional rotation/handling to print the G1 and G2 grid lines.

Therefore, there is a need for a method and inkjet printer for depositing G1 and G2 grid lines in one printing/machine direction, so as to fulfill the mass production requirements of low circle time and high throughput without additional rotation/handling to print the G1 and G2 grid lines, and the requirements of good line width control, deposition precision, compatibility with more complex geometries (e.g. cross finger), compatibility with large-area solar modules, reduced material consumption.

Document WO2014/081051A1 describes an inkjet printer for forming crisscrossed conductive lines (fingers and busbars) by moving a printhead comprising nozzles in one direction (Y), which is the direction of the fingers, and printing in one single pass the fingers and the busbars.

### Summary

The object of the present application is to provide an inkjet printer for forming crisscrossed conductive lines of a thin-film solar module, which is capable of depositing crisscrossed conductive lines in one machine/print direction.

An embodiment of the present application provides an inkjet printer for forming crisscrossed conductive lines of a thin-film solar module, the crisscrossed conductive lines being located on a surface of a front electrode layer of the thin-film solar module away from a substrate of the thin-film solar module, and comprising a G1 grid line group and a G2 grid line group perpendicular to each other, grooves for forming the G2 grid line group being located on the surface of the front electrode layer away from the substrate, the inkjet printer comprising: a controller; and at least one inkjet print head moveable linearly with respect to the thin-film solar module, wherein each of the at least one inkjet print head comprises a plurality of nozzles arranged in a row, the plurality of nozzles comprises a first group of nozzles and a second group of nozzles, a distance between two adjacent nozzles in the first group of nozzles is the same as a distance between two adjacent G1 grid lines in the G1 grid line group, the second group of nozzles are distributed between adjacent nozzles of the first group of nozzles, wherein the controller is configured to control the at least one inkjet print head to move linearly with respect to the thin-film solar module in a direction perpendicular to the grooves, and control the first group of nozzles and the second group of nozzles in each of the at least one inkjet print head to deposit conductive ink on the surface of the front electrode layer away from the substrate to form the G1 grid line group and the G2 grid line group, the first group of nozzles in each of the at least one inkjet print head are controlled by the controller to continuously deposit the conductive ink in the direction perpendicular to the grooves, the second group of nozzles in each of the at least one inkjet print head are controlled by the controller to deposit the conductive ink into the grooves when the inkjet print head moves over the grooves in the direction perpendicular to the grooves.

In an embodiment of the present application, each G1 grid line in the G1 grid line group is formed by overlap of droplets of the conductive ink deposited by a same nozzle in the direction perpendicular to the grooves.

In an embodiment of the present application, each G2 grid line in the G2 grid line group is formed by inducing the flow of the conductive ink deposited into the grooves along the grooves by capillary force.

In an embodiment of the present application, the conductive ink is nanoparticular or metal-organic-complex precursor ink.

In an embodiment of the present application, a diameter of a droplet of the conductive ink deposited by each of the plurality of nozzles is 40µm to100µm.

In an embodiment of the present application, an inkjet printing speed of the inkjet printer is 300~700mm/s.

Another embodiment of the present application provides an automated metallization system for forming crisscrossed conductive lines of a thin-film solar module, comprising the inkjet printer according to any one of the above embodiments, a first inline eddy current measuring device, an oven unit, an inline inspection camera and a second inline eddy current measuring device, wherein, the thin-film solar module are processed in sequence by the first inline eddy current measuring device, the inkjet printer, the oven unit and the second inline eddy current measuring device by a conveyor, and the thin-film solar module is detected by the inline inspection camera after and/or before the oven unit processes the thin-film solar module, the first inline eddy current measuring device is configured to measure an electrical resistivity of the thin-film solar module; the inkjet printer is configured to print G1 grid lines and G2 grid lines on the front electrode layer of the thin-film solar module; the oven unit is configured to cure the G1 grid lines and the G2 grid lines on the front electrode layer of the thin-film solar module; the inline inspection camera is configured to detect widths and defects of the G1 grid lines and the G2 grid lines; and the second inline eddy current measuring device is configured to measure an electrical resistivity of the thin-film solar module having the cured G1 grid lines and G2 grid lines.

Another embodiment of the present application provides a system for forming a thin-film solar module, comprising the inkjet printer according to any one of the above embodiments.

In an embodiment of the present application, the system further comprises a substrate receiving module that is adapted to receive a substrate, one or more absorbing layer deposition cluster tools having at least one processing chamber that is adapted to deposit a photovoltaic layer stack for power generation on a surface of the substrate, one or more back contact deposition chambers, one or more material removal chambers, a solar cell encapsulation device, an autoclave module, an automated junction box attaching module, and one or more quality assurance modules that are adapted to test and qualify a completely formed thin-film solar module.

The inkjet printer for forming crisscrossed conductive lines of a thin-film solar module according to the embodiment is a new inkjet printer capable of self-aligned inkjet printing the G2 grid line group and the G1 grid line group in the same machine/printing direction. Comparing with conventional inkjet printers or other existing metal grid deposition devices, the inkjet printer for forming crisscrossed conductive lines of a thin-film solar module according to the embodiment shows various advantages in low circle time, high throughput, low CAPEX cost, and good line width control, better grid line aspect ratio and positioning accuracy, compatibility with more complex geometries, compatibility with large-area solar modules and reduced material consumption.

### Brief Description of the Drawings

In order to more clearly describe the technical solutions of the embodiments of the present disclosure or of the prior art, drawings that need to be used in embodiments and the prior art will be briefly described below. Obviously, the drawings provided below are for only some embodiments of the present disclosure. The same reference signs in the drawings indicate the same elements.
Fig. 1 is a cross-section of a single thin-film solar module according to an embodiment of the present application;
Fig. 2 is a top view of a part of the single thin-film solar module as shown in Fig. 1;
Fig. 3 is a top view of a thin-film solar module with crisscrossed conductive lines according to an embodiment of the present application;
Fig. 4 is a flowchart of a method for forming crisscrossed conductive lines of a thin-film solar module according to an embodiment of the present application;
Fig. 5 is a diagram showing the flow of conductive ink in a groove by capillary force;
Fig. 6 is a diagram showing the forming of a G2 grid line by precisely depositing conductive ink into the groove;
Fig. 7 is a perspective view of depositing G1 grid lines in a machine direction by an inkjet print head according to an embodiment of the present application;
Fig. 8 is a top view of depositing G1 grid lines in a machine direction by an inkjet print head according to an embodiment of the present application;
Fig. 9 is a diagram showing the forming of the G1 grid lines;
Fig. 10 is a perspective view of depositing G2 grid lines in a machine direction by an inkjet print head according to an embodiment of the present application;
Fig. 11 is a diagram showing the forming of the G2 grid lines;
Fig. 12 shows an example of an automated metallization system for forming crisscrossed conductive lines of a thin-film solar module according to an embodiment of the present application;
Fig. 13 shows an example of forming crisscrossed conductive lines by an automated metallization system according to an embodiment of the present application;
Fig. 14 shows a first example of an arrangement of an automated metallization system according to an embodiment of the present application;
Fig. 15 shows a second example of an arrangement of an automated metallization system according to an embodiment of the present application;
Fig. 16 shows a third example of an arrangement of an automated metallization system according to an embodiment of the present application;
Fig. 17 shows a fourth example of an arrangement of an automated metallization system according to an embodiment of the present application;
Fig. 18 shows a fifth example of an arrangement of an automated metallization system according to an embodiment of the present application.

### Detailed Description

In order to make the objectives, technical solutions, and advantages of the present application clearer and more understandable, the present application will be described in detail below with reference to the appended drawings and embodiments. Obviously, the described embodiments are only some, and not all, of the embodiments of the present application. All other embodiments obtained based on the embodiments of the present disclosure by those skilled in the art fall into the scope of protection defined by the present disclosure.

A solar module manufactured by the thin-film PV technology can be referred to as a thin-film solar module. The thin-film solar module may include, for example, copper indium gallium selenium (CIGS) thin-film solar module, cadmium telluride (CdTe) thin-film solar module, organic photovoltaic (OPV) thin-film solar module, Perovskite thin-film solar module, dye-sensitized solar cell (DSSC) module, Heterojunction with Intrinsic Thin film (HJT) solar cell modules, and so on.

In general, a thin-film solar cell includes a back electrode layer, an absorber layer, a buffer layer/i-layer, and a front electrode layer in sequence. A thin-film solar module is typically formed by forming a plurality of thin-film solar cells on a large substrate and inter-connecting the thin-film solar cells in monolithic series. The specific structure and production method of various thin-film solar modules are known in the prior art, and thus are not introduced in detail.

The individual layers in a thin-film solar cell are interconnected, as shown in Fig.1. These layers are separated by P1, P2 and P3 structuring lines, respectively. The P1 structuring line and P3 structuring line insulate the back electrode layer and the front electrode layer, and the P2 structuring line serves as an electrical contact between the back electrode layer and the front electrode layer for serial connection of two neighboring cells. Since the structuring area of the P1, P2 and P3 structuring lines does not generate electricity, it usually refers to as the "dead area", see Fig. 2.

To optimize the power conversion efficiency of the solar cell, one approach is often considered, e.g. increasing the transmission of the front electrode layer of the solar cell by reducing the thickness of the front electrode layer and further the photo current generated. However, it will lead to an increase in the sheet resistance of the front electrode layer, causing ensuing conduction losses. To reduce such conduction losses in the front electrode layer, highly conductive narrow metal grid lines (which are referred to as the first type of grid lines) can be applied on the front electrode layer to improve related electrical conductivity, which refers to as a metallization process in the solar module production. In the metallization process, the first type of grid lines is deposited transversely or in the direction perpendicular to the P1/ P2/P3 structuring lines on the top of the front electrode layers of the solar cells at periodic intervals. Further, the first type of grid lines is deposited continuously over the front electrode layers of the solar cells. The P3 structuring line interrupts the first type of grid lines to prevent a short circuit between the front electrodes of one cell and its neighboring cell.

The first type of grid lines can reduce the conduction losses of the front electrode layer. However, the first type of grid lines also lead to an increase in the dead area due to the shading of the first type of grid lines, and further cause additional optical losses. Besides, the application of the first type of grid lines also can lead to a concentrated current at an end of a cell. In the case of a monolithic interconnected cell, the current collected at the first type of grid lines flows to an end of the cell and needs to be evenly distributed at the beginning of the next cell. Otherwise, further conduction losses in the front and back electrode layers will arise.

Therefore, an additional grid line, which is referred to as the second type of grid line, is deposited within the dead area and perpendicular to the first type of grid line. Here, the first type of grid line is denoted as G1, and is perpendicular to the P2 structuring line; the second type of grid line is denoted as G2, and is deposited exactly on the P2 structuring line and parallel to the P2 structuring line. The intention of depositing the G2 grid line is to evenly distribute the current and reduce electrical loss along P2 structuring line interconnect between two G1 grid lines, which is caused by current distribution from the G1 grid lines raised at the beginning of the next cell. Since the G2 gird line is placed in the dead area, it will not cause additional optical loss by shading. Besides, the G2 grid line can improve the generation of photo current, which is contributed by the light reflection at the G2 grid line onto the back of the over-layer/front glass and further into the active cell area.

Embodiments of the present application provide a method and an inkjet printer for forming crisscrossed conductive lines of a thin-film solar module, which are capable of depositing crisscrossed conductive lines in one machine/print direction. Furthermore, the inkjet printer may perform the method for forming crisscrossed conductive lines of a thin-film solar module.

Fig. 1 is a cross-section of a single thin-film solar cell 1 according to an embodiment of the present application. The thin-film solar cell 1 includes a back electrode layer 12, an absorber layer 13, a buffer layer/i-layer 14, a front electrode layer 15, a P1 structuring line, a P2 structuring line and a P3 structuring line. The back electrode layer 12 is disposed on a substrate 11. The absorber layer 13 is disposed on the back electrode layer 12. The buffer layer/i-layer 14 is disposed on the absorber layer 13. The front electrode layer 15 is disposed on the buffer layer/i-layer 14.

The back electrode layer 12, the absorber layer 13, the buffer layer/i-layer 14 and the front electrode layer 15 are separated by the P1, P2 and P3 structuring lines. The P1 structuring line extends through the back electrode layer 12, and is filled with a material of the absorber layer 13. The P2 structuring line extends through the buffer layer/i-layer 14 and the absorber layer 13, and is filled with a material of the front electrode layer 15. The P3 structuring line extends through the front electrode layer 15, the buffer layer/i-layer 14 and the absorber layer 13. The P1 structuring line and the P3 structuring line insulate the back electrode layer 12 and the front electrode layer 15, and the P2 structuring line serves as an electrical contact between the back electrode layer 12 and the front electrode layer 15 for serial connection of two neighboring cells. Since the structuring area of the P1, P2 and P3 structuring lines does not generate electricity, it usually refers to as the "dead area", see Fig. 2.

Referring to Fig. 1, crisscrossed conductive lines are located on a surface of the front electrode layer 15 away from the substrate. The crisscrossed conductive lines include a G1 grid line and a G2 grid line.

Fig. 2 is a top view of a part of the single thin-film solar module 1 as shown in Fig. 1. Referring to Figs. 1 and 2, the G1 grid line is perpendicular to the P2 structuring line. The G2 grid line is exactly on the P2 structuring line and parallel to the P2 structuring line. The G1 grid line is perpendicular to the G2 grid line. The G2 grid line is located in the dead area. Since the G2 gird line is placed in the dead area, it will not cause additional optical loss by shading. Furthermore, the G2 grid line can improve the generation of photo current, which is contributed by the light reflection at the G2 grid line onto the back of the over-layer/front glass and further into the active cell area.

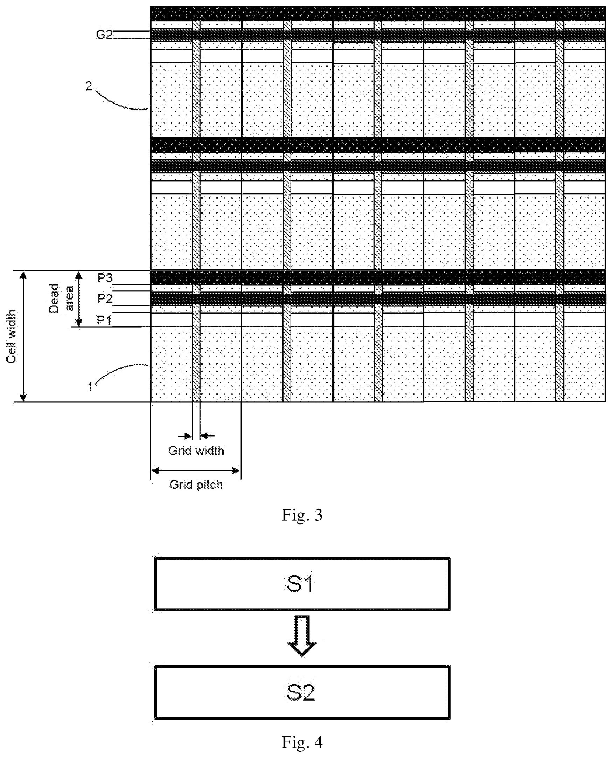

Fig. 3 is a top view of a thin-film solar module 2 having crisscrossed conductive lines according to an embodiment of the present application. The thin-film solar module 2 may include a plurality of solar cells in series on the substrate. For example, as shown in Fig. 3, the thin-film solar module 2 includes three solar cells in series. The crisscrossed conductive lines are located on the surface of the front electrode layer of the thin-film solar module 2 away from the substrate, and include a G1 grid line group and a G2 grid line group perpendicular to one another. The front electrode layer of the thin-film solar module 2 consists of front electrode layers of the plurality of solar cells in series. The G1 grid line group includes a plurality of G1 grid lines separated from one another. The G2 grid line group includes a plurality of G2 grid lines separated from one another. In an embodiment, a distance between two adjacent G1 grid lines in the G1 grid line group may be 100µm~200µm.

As shown in Fig. 3, each thin-film solar cell 1 in the thin-film solar module 2 has a G2 grid line located on a corresponding P2 structuring line and parallel to the P2 Structuring line, and G1 grid lines separated from each other.

Fig. 4 is a flowchart of a method for forming crisscrossed conductive lines of a thin-film solar module according to an embodiment of the present application. The method can be achieved by an inkjet printing technology. The method may be performed by an inkjet printer according to an embodiment of the preset application, and may include steps S1 and S2.

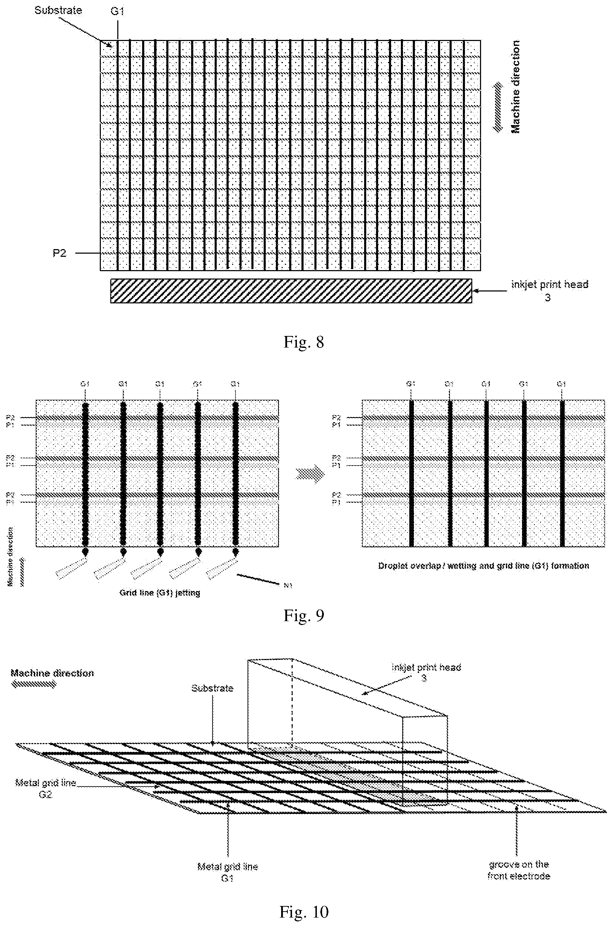

In an embodiment, the inkjet printer may include at least one inkjet print head 3 moveable linearly with respect to the thin-film solar module. Each inkjet print head 3 includes a plurality of nozzles arranged in a row. The plurality of nozzles includes a first group of nozzles N1 and a second group of nozzles N2, as shown in Figs. 9 and 10. A distance between two adjacent nozzles in the first group of nozzles N1 is the same as a distance between two adjacent G1 grid lines in the G1 grid line group, which is equal to a grid pitch. The second group of nozzles N2 are distributed between adjacent nozzles of the first group of nozzles N1.

At step S1, a plurality of grooves are formed on the surface of the front electrode layer away from the substrate.

The grooves on the front electrode layer surface are formed by the following processes. As shown in Fig.1, the buffer/i-layer 14 and absorber layer 13 reveal a groove for forming a P2 structuring line, called P2-groove. The P2-groove extends through the buffer/i-layer 14 and absorber layer 13 to the back electrode by laser or mechanical needle scribing. Then, the front electrode layer is deposited over the entire CIGS layer stack. Accordingly, the P2-groove is filled with the material of the front electrode layer. A further groove structure, that is, a groove for forming the G2 grid line, is formed at a position corresponding to the P2-groove on the surface of the front electrode layer away from the substrate by the laser or mechanical needle scribing.

At step S2, during a linear motion of the inkjet print head with respect to the thin-film solar module in a direction perpendicular to the grooves, conductive ink is continuously deposited by the first group of nozzles on the surface of the front electrode layer away from the substrate in the direction perpendicular to the grooves to form the G1 grid line group, and conductive ink is deposited by the first group of nozzles and the second group of nozzles into the grooves to form the G2 grid line group when the inkjet print head moves over the grooves in the direction perpendicular to the grooves.

In an embodiment, each of the grooves is located on a corresponding P2 structuring line and parallel to the P2 structuring line. The width of the groove may be 20µm ~30µm.

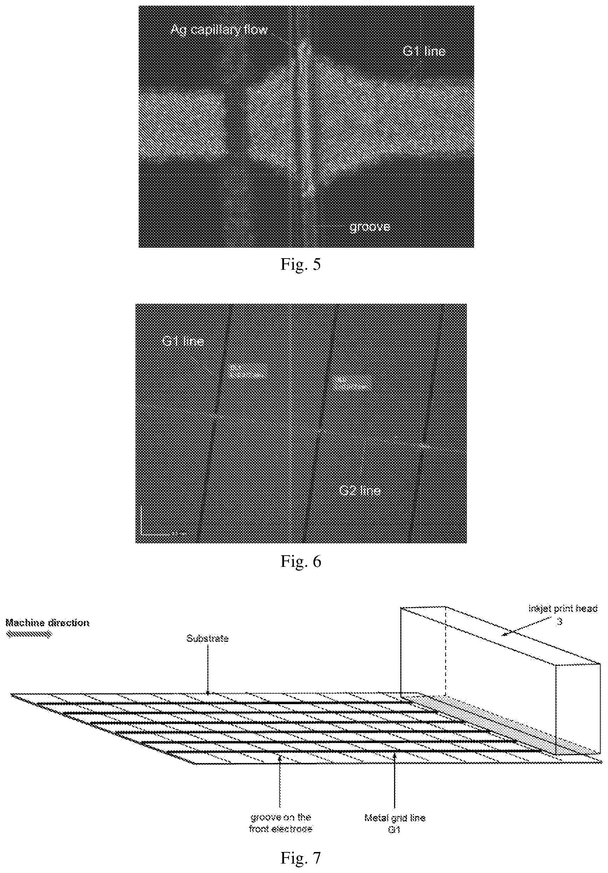

The researcher found that after ink droplets are placed into the groove, the ink droplets will flow in the groove by capillary force, as shown in Fig. 5. The width of the groove is generally 20µm ~30µm, and is far below the diameter of ink droplets of 40µm~100µm. Once ink droplets jetted in a machine/printing direction can be placed precisely into the groove, they can overcome the spacing of few hundred micrometers between the droplets to form a continuous G2 grid line within the groove by self-alignment, as shown in Fig.6. Otherwise, if these droplets are deposited next to the groove, they will only form discrete dots causing additional shunts or optical losses, when they are in the active cell area of the solar module. The machine/printing direction is a direction in which the inkjet print head moves linearly with respect to the thin-film solar module. The direction is perpendicular to the groove on the front electrode layer, that is, perpendicular to the P2 structuring line.

In an embodiment, the conductive ink for forming the G1 grid line and the G2 grid line may be nanoparticular or metal-organic-complex precursor ink. The main solid contents used in the ink can be Ag, Cu, Al, or other conductive nanoparticles or their derivatives.

Fig. 5 is a diagram showing the flow of conductive ink in a groove by capillary force. Fig. 6 is a diagram showing the forming of a G2 grid line by precisely depositing conductive ink into the groove. As shown in Fig. 5, after the conductive ink for printing the G2 grid line is deposited into the groove, the conductive ink flows along the groove by means of the capillary force, which can overcome the spacing of few hundred micrometers between the droplets to form a continuous G2 grid line within the groove by self-alignment. In this way, the G2 grid lines can be formed during the printing of the G1 grid lines in the machine/printing direction. In other words, the inkjet print head may deposit the G1 grid line group and the G2 grid line group in one machine/printing direction.

In an embodiment, the G1 grid line group and the G2 grid line group are possible to be printed in one-step. Alternatively, the G1 grid line group and the G2 grid line group may be also printed separately. The machine/printing direction will remain unchanged, no matter of the sequence of printing the G1 grid line group and the G2 grid line group. This can enable saving in space, CAPEX cost and circle time.

In an embodiment, the G1 grid line group and the G2 grid line group may be printed separately in the same machine/printing direction. For example, the G1 grid line group is first deposited, and then the G2 grid line group is deposited after the deposition of the G1 grid line group is completed. Alternatively, the G2 grid line group is first deposited, and then the G1 grid line group is deposited after the deposition of the G2 grid line group is completed. An example process of first depositing the G1 grid line group and then depositing the G2 grid line group will be introduced as follows.

Figs. 7-11 show a process of first depositing the G1 grid line group and then depositing the G2 grid line group by an inkjet printer for forming crisscrossed conductive lines of a thin-film solar module according to an embodiment of the present application.

Referring to Figs. 7-11, an embodiment of the present application further provides an inkjet printer for forming crisscrossed conductive lines of a thin-film solar module. In the embodiment, the inkjet printer may comprise a controller (not shown) and at least one inkjet print head 3 moveable linearly with respect to the thin-film solar module. Each of the at least one inkjet print head 3 comprises a plurality of nozzles arranged in a row. The plurality of nozzles comprises a first group of nozzles N1 and a second group of nozzles N2, as shown in Figs. 9 and 10. A distance between two adjacent nozzles in the first group of nozzles N1 is the same as a distance between two adjacent G1 grid lines in the G1 grid line group. The second group of nozzles are distributed between adjacent nozzles of the first group of nozzles.

The controller controls the at least one inkjet print head 3 to move linearly with respect to the thin-film solar module in a direction perpendicular to the grooves, and controls the first group of nozzles N1 and the second group of nozzles N2 in each of the at least one inkjet print head 3 to deposit conductive ink on the surface of the front electrode layer away from the substrate to form the G1 grid line group and the G2 grid line group.

The first group of nozzles N1 in each of the at least one inkjet print head 3 are controlled by the controller to continuously deposit the conductive ink in the direction perpendicular to the grooves.

The second group of nozzles N2 in each of the at least one inkjet print head 3 are controlled by the controller to deposit the conductive ink into the grooves when the inkjet print head moves over the grooves in the direction perpendicular to the grooves.

Fig. 7 is a perspective view of depositing G1 grid lines in a machine direction by an inkjet print head according to an embodiment of the present application. Fig. 8 is a top view of depositing G1 grid lines in a machine direction by an inkjet print head according to an embodiment of the present application. Fig. 9 is a diagram showing the forming of the G1 grid lines.

Referring to Figs. 7 and 8, the inkjet print head moves with respect to the thin-film solar module in a machine direction to deposit the G1 grid line group on the top of the front electrode layer (or other interfacial layers) in the thin-film solar module, that is, on the surface of the front electrode layer away from the substrate. In general, the G1 grid lines will be deposited continuously in a direction perpendicular to P2 structuring lines. In the embodiment, the G1 grid line group is deposited by the inkjet print head on the entire thin-film solar module in one-step. This can reduce production circle time and increase production throughput.

Referring to Fig. 9, the formation of each G1 grid line in the G1 grid line group can be realized by overlap of deposited droplets in the machine direction, that is, in the direction perpendicular to P2 structuring lines. The critical size of droplets for forming a single G1 grid line may be 10∼25 pl, in order to form a narrow G1 grid line in a width of 40∼100µm. Referring to Fig. 9, the first group of nozzles N1 in the inkjet print head 3 are used to deposit droplets for forming the G1 grid line group. The distance between two adjacent nozzles in the first group of nozzles N1 is the same as the distance between two adjacent G1 grid lines in the G1 grid line group. During the printing of the G1 grid line group, the second group of nozzles N2 in the inkjet print head 3 are inactive, that is, do not deposit the droplets.

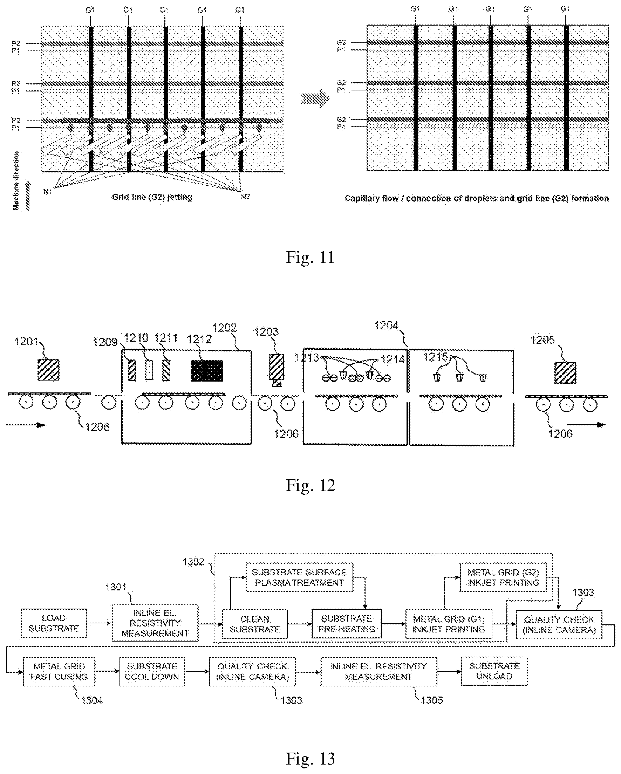

Fig. 10 is a perspective view of depositing G2 grid lines in a machine direction by an inkjet print head according to an embodiment of the present application. Fig. 11 is a diagram showing the forming of the G2 grid lines.

Referring to Fig. 10, the inkjet print head moves with respect to the thin-film solar module with the G1 grid line group in the same machine direction as the G1 grid line group, that is, in the direction perpendicular to the P2 structuring lines, to deposit the G2 grid line group on the top of the front electrode layer (or other interfacial layers) in the thin-film solar module, that is, on the surface of the front electrode layer away from the substrate. In the embodiment, the G2 grid line group is deposited by the inkjet print head on the entire thin-film solar module in one-step. This can reduce production circle time and increase production throughput.

Referring to Fig. 11, in the embodiment, the second group of nozzles N2 of the inkjet print head are distributed between adjacent nozzles of the first group of nozzles. During the printing of each G2 grid line in the G2 grid line group, when the inkjet print head moves over a groove in the front electrode layer in the direction perpendicular to the groove, all of nozzles (including the first group of nozzles N1 and the second group of nozzles N2) in the inkjet print head deposit the conductive ink into the groove to form the G2 grid line. After the conductive ink enters into the groove, the conductive ink flows along the groove by means of capillary force, to from the G2 grid line. In this way, the G2 grid line will stay in the groove and not across the edges of the P1 and P3 structuring lines. This can reduce the shunting or additional optical loss issues.

In an embodiment, the G1 grid line group and the G2 grid line group may be formed in one-step in the machine/printing direction. Specifically, during the motion of the inkjet print head with respect to the thin-film solar module in the machine/printing direction, i.e., the direction perpendicular to the P2 structuring lines, the controller controls the first group of nozzles N1 in the inkjet print head 3 to continuously deposit the conductive ink, and controls the second group of nozzles N2 in the inkjet print head 3 to deposit the conductive ink only when the inkjet print head moves over the grooves in the front electrode layer. In this way, the G1 grid line group and the G2 grid line group can be formed in one-step.

In an embodiment, the printing of G1 or G2 grid lines may be single or multiple passes, in order to achieve the optimal line width and height for the best device performance in the solar modules.

In an embodiment, after the G1 grid line group and the G2 grid line group are deposited on the surface of the front electrode layer (or other interface layers) in the thin-film solar module away from the substrate by the inkjet printing technology, the deposited G1 grid line group and G2 grid line group are cured/annealed to be converted into bulk material without or with very less organic residues within the grain structures. By this means, good electrical conductivity can be achieved. Thereby, the curing temperature for the deposited G1 grid line group and G2 grid line group may be 120~250°C. The curing process may be implemented via various convective ovens (such as batch, conveyor, or hybrid hot air ovens, etc.), or radiative heating aggregates (infrared emitter, UV curer, microwave oven, etc.), or conductive hot plate.

Additionally, the inkjet printing of the G2 grid line group in same printing/machine direction as the G1 Grid line group, through capillary flow induced self-alignment, is not possible to be realized by other special contactless jetting technologies, such as dispensing or aerosol jetting.

In comparison to the inkjet printing (discrete as dot on dot via piezo crystal) in the present application, the dispensing is one continuous jetting method via hydraulic pressure to inject liquid ligaments in a typical diameter from 20 micrometers to few hundred micrometers. In the case of using multi-nozzle dispensing, a dimension of a single nozzle unit of the dispensing is in millimeter range (5~10mm), comparing with the nozzle spacing (100-200µm) in the inkjet printing. In addition, the viscosity of applied dispensing conductive metal particular ink is about 100∼1000 times of the ones of inkjet conductive inks. Therefore, it is almost impossible to form the G2 grid line in the same printing direction as the G1 grid line by inducing the flow of the dispensing conductive metal particular ink in the G2 groove through capillary force. To note, it is only possible to deposit the G2 grid line by a single nozzle dispensing in a direction perpendicular to a printing direction of the G1 grid line.

The aerosol jetting is a jetting method using ink aerosol generated by ultrasonic or pneumatic atomization. This method can generate grid lines having a typical width of 5~20µm. In this method, it is only possible to print the G2 grid lines with a single aerosol jetting nozzle in a direction perpendicular to the printing direction of the G1 grid lines. For multi-nozzle aerosol jetting, its nozzle spacing is similar as the nozzle spacing of the dispensing. The aerosol jetting does not jet droplets (in picoliters in the inkjet printing) or ligaments, but does jet ink aerosols. Therefore, it is impossible to form the G2 grid line in the same printing direction as the G1 grid line by inducing the flow of the ink aerosol in the G2 groove through capillary force.

The method and the inkjet printer for forming crisscrossed conductive lines of a thin-film solar module according to the embodiments of the present application can have the following advantages. The front electrode layer having the G2 grid lines can be further drastically enhanced in terms of electrical conductivity. The inherent shape of the groove located over the structuring line and parallel to the P2 structuring line helps to restrain the width of the G2 gird line. The G2 grid line having a very narrow width can be achieved depending on the width of the groove, which can be hardly achieved on normal substrate surface by the inkjet printing. Since the G2 grid line has the narrow width, the possibility of the G2 grid line exceeding the active area will be further reduced, thereby reducing the shunting or optical losses. In addition, by the method and the inkjet printer of the present application, the G2 grid lines and the G1 grid lines can be printed in the same machine/printing direction, which can save a lot of CAPEX cost in terms of equipment design, and improve the production throughput.

Compared to vacuum coating through mask, the G1 grid line group and the G2 grid line group will be directly deposited onto the target surface by the inkjet printing method without unnecessary waste on working chamber or masks. Compared to the screen printing method, the inkjet printing method is much more flexible in adjusting the grid line pitch or pattern design. And, the inkjet printing method has no limitation in the size of the thin-film solar module. Since the inkjet printing method is a digital printing method, it will have no large deviation of a printing width and shape in a certain area for a large substrate caused by limited mechanical properties of a screen mesh in the case of the screen printing method. The disposition accuracy of metal grid lines formed by the inkjet printing method is also much higher than those conventional printing methods. The inkjet printing method enables the ink jetted G2 grid lines exactly into the grooves, which avoids the shunting or additional optical losses caused by inaccurate positioning of the G2 grid lines.

The technical aspects of the method and the inkjet printer for forming crisscrossed conductive lines (G1 grid lines and G2 grid lines) have been described above. Concerning the mass production of the thin-film solar module of enhanced front contact, there is generally a need for an automated metallization process line to assure that the crisscrossed conductive lines (G1 grid lines and G2 grid lines) can be manufactured in a repeatable and reliable manner.

With strong price competition of Si solar modules, a technically simple and low-cost one-step metallization method is highly recommended for the thin-film solar module production. Further, such a method should provide fast deposition rate, high production throughput and yield.

In comparison to Si-PV wafers of 6"×6" (15.24cm×15.24cm), a full size thin-film module is commonly much larger as a single piece in the manufacturing process. The length of the overall module may be 1200~2000mm, and the width may be 600~1300mm. Therefore, there is a need for an appropriate way to apply even line width and height over entire active area for forming crisscrossed conductive lines (G1 grid lines and G2 grid lines) on the thin-film solar module. In addition, the G1 and G2 grid lines need to be deposited in two perpendicular direction 0° and 90°. This requires high deposition accuracy over entire large area.

An embodiment of the present application further provides an automated metallization system. The system may include the inkjet printer according to the embodiment of the present application. In this system, the inkjet printer is used for the deposition of a pattern of crisscrossed conductive lines (metal contact lines) on a coated substrate for a thin-film solar module, that is, the front electrode layer of the thin-film solar module. At least two grid line groups (G1 and G2 grid line groups) in the pattern of crisscrossed conductive lines are formed in different directions (e.g. 0° and 90°) with respect to the P2 structuring lines or grooves. The inkjet printer is provided with a printing station comprising at least one moveable linear printing head with a plurality of fixed ink-jet printing nozzles. During the printing, the coated substrate moves only in one linear direction or rests and the print head moves only in a direction parallel to a substrate transport direction or rests. Furthermore, the at least two groups of nozzles do not always fire simultaneously but operate in such a way that the relative linear movement of the print head and the substrate and the time-controlled firing of the at least two groups of nozzles result in the pattern of at least two grid line groups oriented in different directions. Comparing with conventional solar metallization system/line using inkjet printing or other standard metal grid deposition technologies, the automated metallization system of the present application shows various advantages in low circle time, high throughput, low CAPEX cost, and better grid line aspect ratio and positioning accuracy.

The automated metallization system of the present application may further include at least one fast curing unit, an inline quality inspection device (e.g., inline inspection camera) and inline eddy current measuring devices (e.g., eddy current anisotropic sheet resistance devices), which fulfill high throughput mass production requirements for solar modules. The curing unit enables fast convection of deposited crisscrossed conductive lines (G1 and G2 grid lines) to achieve the optimal electric conductivity. The inline quality inspection device can automatically characterize the properties of formed crisscrossed conductive lines (G1 and G2 grid lines) to assure that the performance of the lines is within a desired performance range and that the combination with further process steps creates a solar cell device that meets the functional and performance specifications required by the solar cell device manufacturer.

The automated metallization system according to the embodiment of the present application is based on the new inkjet printing process for forming G1 and G2 grid lines in one step in the same printing/machine direction according to the embodiment of the present application. It can fulfill requirements for thin-film solar module production: good line width control, flexible pattern design, essential ink/material consumption for cost reduction, and high deposition precision for G1 and G2 grid line group over entire large area. In addition, it can enable a significant saving in CAPEX cost in terms of equipment design, and enhances the production throughput.

During production, G1 and G2 grid lines are deposited by using inkjet printing conductive inks on top of a front electrode layer (or other interfacial layers) in the thin-film solar module. The number of deposited G1 grid lines on one full size coated substrate may be larger than 1000 and the number of deposited G2 grid lines on one full size coated substrate may be larger than 200. The positioning accuracy of G1 and G2 grid lines is ±5~10µm in the direction parallel to the P2 structuring line and the direction perpendicular to the P2 structuring line. The inkjet printing speed may be 300~700 mm/s, which could meet low circle time of 10~30s for one full size coated substrate. In case of printing G2 grid lines in a conventional manner, the rotation/handling and ensuing second-time alignment of the coated substrate will cost additional circle time of 10~15s. During printing, the coated substrate may possess a temperature of 25~85°C, which is done by convective or radiative pre-heating, or additional conductive heating during printing. This is to achieve the narrow grid line without overheating the print head.

For curing process, the coated substrate needs be fast heated to reach its optimal electrical conductivity. Thereby, the temperature of the coated substrate having grid lines could be 120~250°C. The curing process could be implemented via various convective conveyor ovens, e.g. hot air impingement oven, hot air infrared hybrid oven, and so on. The circle time for the curing oven may be 10~30s. The conveyor speed in the curing oven may be 80~200 mm/s. By using such ovens, high production throughput can be reached. Furthermore, the conveyors among the printer, the curing unit, the inline inspection camera and the inline eddy current measuring devices possess a max transport speed of 1000mm/s.

Fig. 12 shows an example of an automated metallization system for forming crisscrossed conductive lines of a thin-film solar module according to an embodiment of the present application. Fig. 13 shows an example of forming crisscrossed conductive lines by the automated metallization system according to an embodiment of the present application.

The automated metallization system shown in Fig. 12 comprises a first inline eddy current measuring device 1201, an inkjet printer 1202, an oven unit 1204, an inline inspection camera 1203 and a second inline eddy current measuring device 1205. The inkjet printer 1202 is the same as the inkjet printer as shown in Figs. 7-11.

Referring to Fig.12, the thin-film solar module may be processed in sequence by the first inline eddy current measuring device 1201, the inkjet printer 1202, the oven unit 1204 and the second inline eddy current measuring device 1205 by a conveyor. The thin-film solar module may be detected by the inline inspection camera 1203 after and/or before the oven unit 1204 processes the thin-film solar module. The first inline eddy current measuring device 1201 may measure an electrical resistivity of the thin-film solar module. The inkjet printer 1202 may print G1 grid lines and G2 grid lines on the front electrode layer of the thin-film solar module. The oven unit 1204 may cure the G1 grid lines and the G2 grid lines on the front electrode layer of the thin-film solar module. The inline inspection camera 1203 may detect widths and defects of the G1 grid lines and the G2 grid lines. The second inline eddy current measuring device 1205 may measure an electrical resistivity of the thin-film solar module having the cured G1 grid lines and G2 grid lines.

Referring to Figs. 12 and 13, a quality inspection process is optional, and may be implemented before a printing process 1302, or between the printing process 1302 and a curing process 1304, or after the curing process 1304 during production. In the embodiment, the system is adapted to receive an unprocessed coated substrate for the thin-film solar module from an infeed robot (or upstream conveyor) 1207. In 1301, the electrical resistivity of the substrate is measured by the first inline eddy current measuring device 1201 before the printing process. In 1302, the coated substrate will be transferred to the inkjet printer 1202 and perform multiple printing relevant steps there: particle removal/cleaning by an air blade 1209, surface energy modification by a certain atmospheric plasma treatment 1210, processing the substrate by a (convective, radiative or hybrid) pre-heating unit 1211 to a certain temperature level, printing G1 and G2 grid lines by using multiple print heads 1212 on a heated or non-heated suction table. In 1304, the coated substrate having the printed G1 and G2 grid lines will be further transported to the oven unit 1204 for the curing process. In the oven, mixed infrared emitters 1213 and hot air impingement slots 1214 may be installed in the heating zone of the oven, in order to fast cure the printed G1 and G2 grid lines for achieving higher electrical conductivity. In order to avoid the thermal influence on electrical measurement later, the coated substrate may be fast cooled down to a desired temperature by an optional air cooling 1215 in the oven. In 1303, the widths and defects (e.g. line breaks, line broadening, etc.) of the printed G1 and G2 grid lines may be detected by the inline inspection camera 1203. The inline inspection camera 1203 may be used for 2D-optical check of line width and line defects. As shown in Fig. 13, the inline inspection camera 1203 may be disposed between the inkjet printer 1202 and the oven unit 1204 and/or after the oven unit 1204. When the grid structure comprising the printed G1 and G2 grid lines achieves its optimal electrical conductivity after curing in the oven, the resistivity of the coated substrate will be again measured by the second inline eddy current measuring device 1205 in 1305. The result measured by the inline eddy current measuring device 1205 and the result measured by the first eddy current measuring device 1201 can be used for evaluating the electrical performance of the G1 and G2 grid line groups. Finally, the thin-film solar module with the G1 and G2 grid line groups can be transferred to an outfeed robot (or downstream conveyor) 1208.

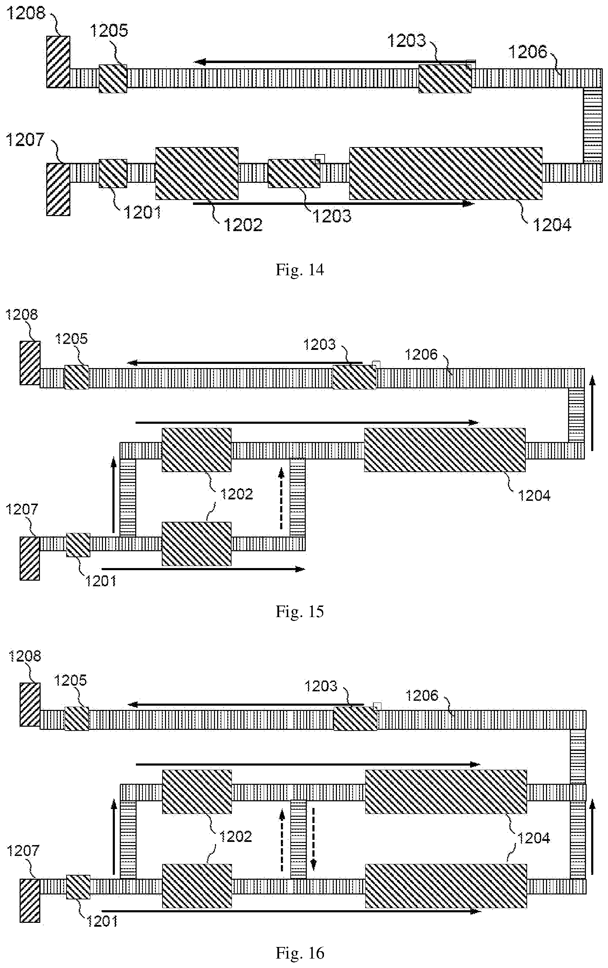

Figs. 14 to 18 show various examples of an arrangement for an automated metallization system in a factory layout, respectively. It is to be noted that these examples illustrate only typical embodiments of this invention and are therefore not intended to limit of the number of device units in the system. Other examples of higher production throughput are also allowed in the present application.

Fig. 14 shows a first example of an arrangement of an automated metallization system according to an embodiment of the present application. The automated metallization system shown in Fig. 14 includes a first inline eddy current measuring device 1201, an inkjet printer 1202, an oven unit 1204 and a second inline eddy current measuring device 1205 disposed in sequence and two inline inspection cameras 1203, which are connected by a conveyor 1206. One of the two inline inspection cameras 1203 is disposed between the inkjet printer 1202 and the oven unit 1204, and the other is disposed between the oven unit 1204 and the second inline eddy current measuring device 1205. Referring to Fig. 14, the thin-film solar module is transferred to the first inline eddy current measuring device 1201 from the infeed robot (or upstream conveyor) 1207 by the conveyor 1206. After the first inline eddy current measuring device 1201 measures the electrical resistivity of the solar module, the solar module is transferred to the inkjet printer 1202. The inkjet printer 1202 prints the G1 and G2 grid lines on the surface of the front electrode layer of the solar module away from the substrate. The solar module with the printed G1 and G2 grid lines is transferred to the inline inspection camera 1203 for quality detection, and then transferred to the oven unit 1204 for curing the printed G1 and G2 grid lines. The solar module with the cured G1 and G2 grid lines is transferred to the inline inspection camera 1203 for further quality detection. Then, the solar module with the cured G1 and G2 grid lines is transferred to the second inline eddy current measuring device 1205 to measure the electrical resistivity of the solar module again. Finally, the solar module with the cured G1 and G2 grid lines is transferred to the outfeed robot (or downstream conveyor) 1208.

Fig. 15 shows a second example of an arrangement of an automated metallization system according to an embodiment of the present application. For the sake of clarity, a difference between the arrangement of the automated metallization system shown in Fig. 15 and the arrangement shown in Fig. 14 is only described. In Fig. 15, there is no inline inspection camera 1203 between the inkjet printer 1202 and the oven unit 1204. The automated metallization system shown in Fig. 15 has two parallel inkjet printers 1202. The two parallel inkjet printers 1202 are connected to the oven unit 1204 by the conveyor 1206, respectively. The solar module can be transferred to the oven unit 1204 after being processed by any one of the two parallel inkjet printers 1202.

Fig. 16 shows a third example of an arrangement of an automated metallization system according to an embodiment of the present application. For the sake of clarity, a difference between the arrangement of the automated metallization system shown in Fig. 16 and the arrangement shown in Fig. 15 is only described. The automated metallization system shown in Fig. 16 has two parallel inkjet printers 1202 and two parallel inkjet oven units 1204. The downstream of two parallel inkjet printers 1202 are connected by one conveyor, so that the solar module processed by any one the two inkjet printers 1202 may be transferred to any one of the two oven units 1204.

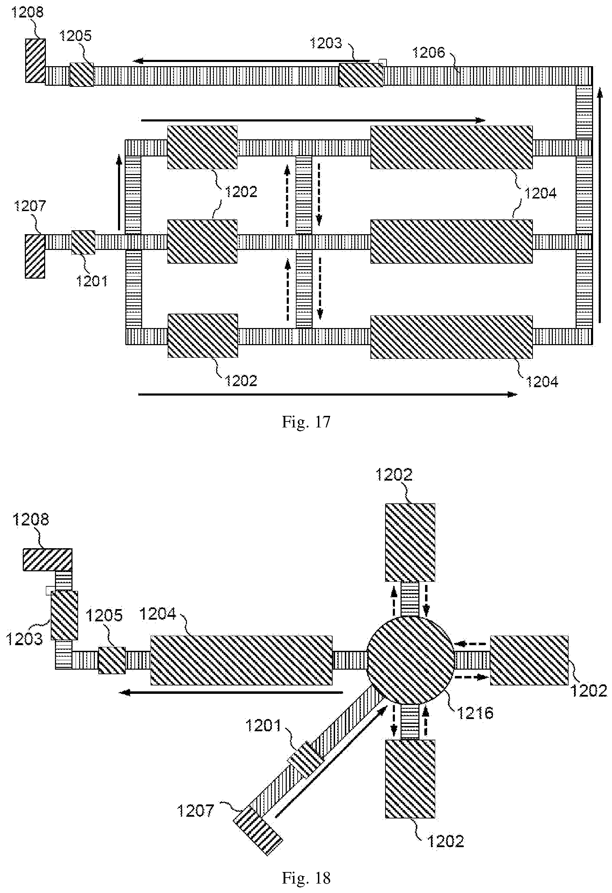

Fig. 17 shows a fourth example of an arrangement of an automated metallization system according to an embodiment of the present application. For the sake of clarity, a difference between the arrangement of the automated metallization system shown in Fig. 17 and the arrangement shown in Fig. 16 is only described. The automated metallization system shown in Fig. 17 has three parallel inkjet printers 1202 and three parallel inkjet oven units 1204. The downstream of the three parallel inkjet printers 1202 are connected by two conveyors, so that the solar module processed by any one the three inkjet printers 1202 may be transferred to any one of the three oven units 1204.

Fig. 18 shows a fifth example of an arrangement of an automated metallization system according to an embodiment of the present application. For the sake of clarity, a difference between the arrangement of the automated metallization system shown in Fig. 18 and the arrangement shown in Fig. 14 is only described. The automated metallization system shown in Fig. 18 has a center circular handling system 1216. The center circular handling system 1216 is connected to the oven unit 1204 by the conveyor. Furthermore, the center circular handling system 1216 is connected to three inkjet printer 1202 by three conveyors, respectively. The infeeding and outfeeding of the thin-film solar module will take place on the same conveyor between the center circular handling system 1216 and an individual inkjet printer 1202. Such arrangement can be used to save CAPEX cost of conveyor units and also the factory layout space.

In the present application, the automated metallization system may have any number of inkjet printers 1202 and oven units 1203. Further, the number of other devices is not limited in the present application.

An embodiment of the present application further provides a system for forming a thin-film solar module. The system forms a photovoltaic device or solar cell by using processing modules that are adapted to perform one or more steps in the formation process of the solar module. The automated solar cell factory is generally an arrangement of automated processing modules and automation equipment that is used to form solar cell devices. The automated solar cell factory thus generally comprises the system for forming the thin-film solar module. The system may include an inkjet printer according to the embodiment of the present application. The system may further include a substrate receiving module that is adapted to receive a substrate, one or more absorbing layer deposition cluster tools having at least one processing chamber that is adapted to deposit a photovoltaic layer stack for power generation such as a silicon-containing layer, CIGS layer stack, CdTe layer stack, OPV layer stack, perovskite layer stack, DSSC layer stack, or HIT layer stack on a surface of the substrate, one or more back contact deposition chambers, one or more material removal chambers, a solar cell encapsulation device, an autoclave module, an automated junction box attaching module, and one or more quality assurance modules that are adapted to test and qualify the completely formed solar cell device.

The inkjet printer and method for forming crisscrossed conductive lines of a thin-film solar module according to the embodiments are a new inkjet process capable of self-aligned inkjet printing the G2 grid line group and the G1 grid line group in the same machine/printing direction. Comparing with conventional inkjet processes or other existing metal grid deposition technologies, the inkjet printer and method for forming crisscrossed conductive lines of a thin-film solar module according to the embodiment show various advantages in low circle time, high throughput, low CAPEX cost, and good line width control, better grid line aspect ratio and positioning accuracy, compatibility with more complex geometries, compatibility with large-area solar modules and reduced material consumption.

## Claims

1. An inkjet printer for forming crisscrossed conductive lines of a thin-film solar module (2), the crisscrossed conductive lines being located on a surface of a front electrode layer (15) of the thin-film solar module away from a substrate (11) of the thin-film solar module, and comprising a G1 grid line group and a G2 grid line group perpendicular to each other, grooves for forming the G2 grid line group being located on the surface of the front electrode layer away from the substrate,
wherein the inkjet printer comprises:
a controller; and
at least one inkjet print head (3) moveable linearly with respect to the thin-film solar module, wherein each of the at least one inkjet print head comprises a plurality of nozzles arranged in a row, the plurality of nozzles comprises a first group of nozzles N1 and a second group of nozzles N2 a distance between two adjacent nozzles in the first group of nozzles is the same as a distance between two adjacent G1 grid lines in the G1 grid line group, the second group of nozzles are distributed between adjacent nozzles of the first group of nozzles,
wherein the controller is configured to control the at least one inkjet print head to move linearly with respect to the thin-film solar module in a direction perpendicular to the grooves, and control the first group of nozzles and the second group of nozzles in each of the at least one inkjet print head to deposit conductive ink on the surface of the front electrode layer away from the substrate to form the G1 grid line group and the G2 grid line group,
the first group of nozzles in each of the at least one inkjet print head are controlled by the controller to continuously deposit the conductive ink in the direction perpendicular to the grooves,
the second group of nozzles in each of the at least one inkjet print head are controlled by the controller to deposit the conductive ink into the grooves when the inkjet print head moves over the grooves in the direction perpendicular to the grooves.

2. The inkjet printer of claim 1, wherein each G1 grid line in the G1 grid line group is formed by overlap of droplets of the conductive ink deposited by a same nozzle in the direction perpendicular to the grooves.

3. The inkjet printer of claim 1, wherein each G2 grid line in the G2 grid line group is formed by inducing the flow of the conductive ink deposited into the grooves along the grooves by capillary force.

4. The inkjet printer of claim 1, wherein the conductive ink is nanoparticular or metal-organic-complex precursor ink.

5. The inkjet printer of claim 1, wherein a diameter of a droplet of the conductive ink deposited by each of the plurality of nozzles is 40µm to100µm.

6. The inkjet printer of claim 1, wherein an inkjet printing speed of the inkjet printer is 300~700mm/s.

7. An automated metallization system for forming crisscrossed conductive lines of a thin-film solar module, comprising the inkjet printer (1202) of any one of claims 1-6, a first inline eddy current measuring device (1201), an oven unit (1204), an inline inspection camera (1203), a second inline eddy current measuring device (1205),
wherein, the thin-film solar module are processed in sequence by the first inline eddy current measuring device, the inkjet printer, the oven unit and the second inline eddy current measuring device by means of a conveyor, and the thin-film solar module is detected by the inline inspection camera after and/or before the oven unit processes the thin-film solar module,
the first inline eddy current measuring device is configured to measure an electrical resistivity of the thin-film solar module;
the inkjet printer is configured to print G1 grid lines and G2 grid lines on the front electrode layer of the thin-film solar module;
the oven unit is configured to cure the G1 grid lines and the G2 grid lines on the front electrode layer of the thin-film solar module;
the inline inspection camera is configured to detect widths and defects of the G1 grid lines and the G2 grid lines; and
the second inline eddy current measuring device is configured to measure an electrical resistivity of the thin-film solar module having the cured G1 grid lines and G2 grid lines.

8. A system for forming a thin-film solar module, comprising the inkjet printer of any one of claims 1-6.

9. The system of claim 8, further comprising a substrate receiving module that is adapted to receive a substrate, one or more absorbing layer deposition cluster tools having at least one processing chamber that is adapted to deposit a photovoltaic layer stack for power generation on a surface of the substrate, one or more back contact deposition chambers, one or more material removal chambers, a solar cell encapsulation device, an autoclave module, an automated junction box attaching module, and one or more quality assurance modules that are adapted to test and qualify a completely formed thin-film solar module.

## Patentansprüche

1. Tintenstrahldrucker zum Bilden überkreuzter leitender Leitungen eines Dünnschicht-Solarmoduls (2), wobei sich die überkreuzten leitfähigen Leitungen auf einer Oberfläche einer vorderen Elektrodenschicht (15) des Dünnschicht-Solarmoduls entfernt von einem Substrat (11) des Dünnschicht-Solarmoduls befinden, und umfassend eine G1-Gitterliniengruppe und eine G2-Gitterliniengruppe rechtwinklig zueinander, wobei sich Rillen zum Bilden der G2-Gitterliniengruppe auf der Oberfläche der vorderen Elektrodenschicht weg von dem Substrat befinden,
wobei der Tintenstrahldrucker umfasst:
eine Steuerung; und
mindestens einen Tintenstrahldruckkopf (3), der in Bezug auf das Dünnschicht-Solarmodul linear beweglich ist,
wobei jeder des mindestens einen Tintenstrahldruckkopfes eine Vielzahl von Düsen umfasst, die in einer Reihe angeordnet sind, die Vielzahl von Düsen eine erste Gruppe von Düsen N1 und eine zweite Gruppe von Düsen N2 umfasst, ein Abstand zwischen zwei benachbarten Düsen in der ersten Gruppe von Düsen gleich einem Abstand zwischen zwei benachbarten G1-Gitterlinien in der G1-Gitterliniengruppe ist, die zweite Gruppe von Düsen zwischen benachbarten Düsen der ersten Gruppe von Düsen verteilt ist,
wobei die Steuerung dazu ausgelegt ist, den mindestens einen Tintenstrahldruckkopf so zu steuern, dass er sich in Bezug auf das Dünnschicht-Solarmodul in einer Richtung rechtwinklig zu den Rillen linear bewegt, und die erste Gruppe von Düsen und die zweite Gruppe von Düsen in jedem des mindestens einen Tintenstrahldruckkopfes so zu steuern, dass leitfähige Tinte auf der Oberfläche der vorderen Elektrodenschicht weg von dem Substrat abgeschieden wird, um die G1-Gitterliniengruppe und die G2-Gitterliniengruppe zu bilden,
die erste Gruppe von Düsen in jedem des mindestens einen Tintenstrahldruckkopfes durch die Steuerung so gesteuert wird, dass die leitfähige Tinte kontinuierlich in der Richtung rechtwinklig zu den Rillen abgeschieden wird,
die zweite Gruppe von Düsen in jedem des mindestens einen Tintenstrahldruckkopfes durch die Steuerung so gesteuert wird, dass die leitfähige Tinte in die Rillen hinein abgeschieden wird, wenn sich der Tintenstrahldruckkopf in der Richtung rechtwinklig zu den Rillen über die Rillen bewegt.

2. Tintenstrahldrucker nach Anspruch 1, wobei jede G1-Gitterlinie in der G1-Gitterliniengruppe durch Überlappung von Tröpfchen der leitfähigen Tinte gebildet wird, die durch die gleiche Düse in der Richtung rechtwinklig zu den Rillen abgeschieden werden.

3. Tintenstrahldrucker nach Anspruch 1, wobei jede G2-Gitterlinie in der G2-Gitterliniengruppe durch Induzieren des Flusses der leitfähigen Tinte gebildet wird, die durch Kapillarkraft entlang der Rillen in die Rillen hinein abgeschieden wird.

4. Tintenstrahldrucker nach Anspruch 1, wobei die leitfähige Tinte nanopartikuläre Tinte oder Tinte mit metallorganischem Komplexvorläufer ist.

5. Tintenstrahldrucker nach Anspruch 1, wobei ein Durchmesser eines Tröpfchens der leitfähigen Tinte, das durch jede der Vielzahl von Düsen abgeschieden wird, 40 µm bis 100 µm beträgt.

6. Tintenstrahldrucker nach Anspruch 1, wobei eine Tintenstrahldruckgeschwindigkeit des Tintenstrahldruckers 300 ∼ 700 mm/s beträgt

7. Automatisiertes Metallisierungssystem zum Bilden überkreuzter leitfähiger Linien eines Dünnschicht-Solarmoduls, umfassend den Tintenstrahldrucker (1202) nach einem der Ansprüche 1-6, eine erste Inline-Wirbelstrommessvorrichtung (1201), eine Ofeneinheit (1204), eine Inline-Inspektionskamera (1203), eine zweite Inline-Wirbelstrommessvorrichtung (1205), wobei das Dünnschicht-Solarmodul nacheinander durch die erste Inline-Wirbelstrommessvorrichtung, den Tintenstrahldrucker, die Ofeneinheit und die zweite Inline-Wirbelstrommessvorrichtung mittels eines Förderers verarbeitet wird, und das Dünnschicht-Solarmodul von der Inline-Inspektionskamera nach und/oder vor der Verarbeitung des Dünnschicht-Solarmoduls durch die Ofeneinheit detektiert wird,
wobei die erste Inline-Wirbelstrommessvorrichtung dazu ausgelegt ist, einen elektrischen spezifischen Widerstand des Dünnschicht-Solarmoduls zu messen;
der Tintenstrahldrucker dazu ausgelegt ist, G1-Gitterlinien und G2-Gitterlinien auf die vordere Elektrodenschicht des Dünnschicht-Solarmoduls zu drucken;
die Ofeneinheit dazu ausgelegt ist, die G1-Gitterlinien und die G2-Gitterlinien auf der vorderen Elektrodenschicht des Dünnschicht-Solarmoduls auszuhärten;
die Inline-Inspektionskamera dazu ausgelegt ist, Breiten und Defekte der G1-Gitterlinien und der G2-Gitterlinien zu detektieren; und
die zweite Inline-Wirbelstrommessvorrichtung dazu ausgelegt ist, einen elektrischen spezifischen Widerstand des Dünnschicht-Solarmoduls mit den ausgehärteten G1-Gitterlinien und G2-Gitterlinien zu messen.

8. System zum Bilden eines Dünnschicht-Solarmoduls, umfassend den Tintenstrahldrucker nach einem der Ansprüche 1-6.

9. System nach Anspruch 8, ferner umfassend ein Substrataufnahmemodul, das dazu eingerichtet ist, ein Substrat aufzunehmen, ein oder mehrere Absorptionsschicht-Abscheidungsclusterwerkzeuge mit mindestens einer Verarbeitungskammer, die dazu eingerichtet ist, einen Photovoltaikschichtstapel zur Stromerzeugung auf einer Oberfläche des Substrats abzuscheiden, eine oder mehrere Rückkontaktabscheidungskammern, eine oder mehrere Materialentfernungskammern, eine Solarzellenverkapselungsvorrichtung, ein Autoklavenmodul, ein automatisiertes Anschlusskastenbefestigungsmodul, und ein oder mehrere Qualitätssicherungsmodule, die dazu eingerichtet sind, ein vollständig gebildetes Dünnschicht-Solarmodul zu testen und zu qualifizieren.

## Revendications

1. Imprimante à jet d'encre pour former des lignes conductrices entrecroisées d'un module solaire à film mince (2), les lignes conductrices entrecroisées étant situées sur une surface d'une couche d'électrode avant (15) du module solaire à film mince à l'écart d'un substrat (11) du module solaire à film mince, et comprenant un groupe de lignes de grille G1 et un groupe de lignes de grille G2 perpendiculaires l'un à l'autre, des rainures pour former le groupe de lignes de grille G2 étant situées sur la surface de la couche d'électrode avant à l'écart du substrat,
l'imprimante à jet d'encre comprenant :
un dispositif de commande ; et
au moins une tête d'impression à jet d'encre (3) mobile linéairement par rapport au module solaire à film mince,
dans laquelle chacune de l'au moins une tête d'impression à jet d'encre comprend une pluralité de buses agencées en une rangée, la pluralité de buses comprend un premier groupe de buses N1 et un second groupe de buses N2, une distance entre deux buses adjacentes dans le premier groupe de buses est la même qu'une distance entre deux lignes de grille G1 adjacentes dans le groupe de lignes de grille G1, les buses du second groupe de buses sont réparties entre des buses adjacentes du premier groupe de buses,
dans laquelle le dispositif de commande est configuré pour commander l'au moins une tête d'impression à jet d'encre pour qu'elle se déplace linéairement par rapport au module solaire à film mince dans une direction perpendiculaire aux rainures, et commander le premier groupe de buses et le second groupe de buses dans chacune de l'au moins une tête d'impression à jet d'encre pour qu'elles déposent de l'encre conductrice sur la surface de la couche d'électrode avant à l'écart du substrat pour former le groupe de lignes de grille G1 et le groupe de lignes de grille G2,
les buses du premier groupe de buses dans chacune de l'au moins une tête d'impression à jet d'encre sont commandées par le dispositif de commande pour déposer de manière continue l'encre conductrice dans la direction perpendiculaire aux rainures,
les buses du second groupe de buses dans chacune de l'au moins une tête d'impression à jet d'encre sont commandées par le dispositif de commande pour déposer l'encre conductrice dans les rainures lorsque la tête d'impression à jet d'encre se déplace par-dessus les rainures dans la direction perpendiculaire aux rainures.

2. Imprimante à jet d'encre selon la revendication 1, dans laquelle chaque ligne de grille G1 dans le groupe de lignes de grille G1 est formée par chevauchement de gouttelettes de l'encre conductrice déposées par une même buse dans la direction perpendiculaire aux rainures.

3. Imprimante à jet d'encre selon la revendication 1, dans laquelle chaque ligne de grille G2 dans le groupe de lignes de grille G2 est formée en induisant l'écoulement de l'encre conductrice déposée dans les rainures le long des rainures par force capillaire.

4. Imprimante à jet d'encre selon la revendication 1, dans laquelle l'encre conductrice est une encre précurseur complexe organométallique ou nanoparticulaire.

5. Imprimante à jet d'encre selon la revendication 1, dans laquelle un diamètre d'une gouttelette de l'encre conductrice déposée par chacune de la pluralité de buses est de 40 µm à 100 µm.

6. Imprimante à jet d'encre selon la revendication 1, dans laquelle une vitesse d'impression à jet d'encre de l'imprimante à jet d'encre est de 300 à 700 mm/s.

7. Système de métallisation automatisé pour former des lignes conductrices entrecroisées d'un module solaire à film mince, comprenant l'imprimante à jet d'encre (1202) selon l'une quelconque des revendications 1 à 6, un premier dispositif de mesure de courant de Foucault en ligne (1201), une unité de four (1204), une caméra d'inspection en ligne (1203), un second dispositif de mesure de courant de Foucault en ligne (1205), dans lequel le module solaire à film mince est traité en séquence par le premier dispositif de mesure de courant de Foucault en ligne, l'imprimante à jet d'encre, l'unité de four et le second dispositif de mesure de courant de Foucault en ligne au moyen d'un convoyeur, et le module solaire à film mince est détecté par la caméra d'inspection en ligne après et/ou avant que l'unité de four traite le module solaire à film mince,
le premier dispositif de mesure de courant de Foucault en ligne est configuré pour mesurer une résistivité électrique du module solaire à film mince ;
l'imprimante à jet d'encre est configurée pour imprimer des lignes de grille G1 et des lignes de grille G2 sur la couche d'électrode avant du module solaire à film mince ;
l'unité de four est configurée pour durcir les lignes de grille G1 et les lignes de grille G2 sur la couche d'électrode avant du module solaire à film mince ;
la caméra d'inspection en ligne est configurée pour détecter des largeurs et des défauts des lignes de grille G1 et des lignes de grille G2 ; et
le second dispositif de mesure de courant de Foucault en ligne est configuré pour mesurer une résistivité électrique du module solaire à film mince ayant les lignes de grille G1 et les lignes de grille G2 durcies.

8. Système pour former un module solaire à film mince, comprenant l'imprimante à jet d'encre selon l'une quelconque des revendications 1 à 6.

9. Système selon la revendication 8, comprenant en outre un module de réception de substrat qui est conçu pour recevoir un substrat, un ou plusieurs outils en grappe de dépôt de couche absorbante ayant au moins une chambre de traitement qui est conçue pour déposer une pile de couches photovoltaïques pour la génération de puissance sur une surface du substrat, une ou plusieurs chambres de dépôt de contact arrière, une ou plusieurs chambres d'enlèvement de matière, un dispositif d'encapsulation de cellule solaire, un module autoclave, un module de fixation de boîte de jonction automatisée, et un ou plusieurs modules d'assurance qualité qui sont conçus pour tester et qualifier un module solaire à film mince complètement formé.
